# EUROPEAN PATENT APPLICATION

(11) **EP 1 870 928 A1**
(43) Date of publication of application: **26.12.2007**
(21) Application number: 06732183.6
(22) Date of filing: 14.04.2006
(51) Int. Cl.: H01L 21/304, B24B 37/00, C09K 3/14

(54) **POLISHING COMPOSITION**

(30) Priority: 14.04.2005 JP 2005117538
(71) Applicant: Showa Denko K.K., Tokyo 105-8518 (JP)
(72) Inventor: UOTANI, Nobuo c/o Shiojiri Plant Showa Denko K.K., Shiojiri-shi, Nagano 3996461 (JP); TAKAHASHI, Hiroshi Shiojiri Plant Showa Denko K.K., Shiojiri-shi, Nagano 3996461 (JP); SATO, Takashi c/o Shiojiri Plant Showa Denko K.K., Shiojiri-shi, Nagano 3996461 (JP); SATO, Hajime c/o Shiojiri Plant Showa Denko K.K., Shiojiri-shi, Nagano 3996461 (JP)
(74) Representative: Strehl Schübel-Hopf & Partner
(86) International application number: PCT/JP2006/308375
(87) International publication number: WO 2006/112519

(57) **Abstract**

In order to polish a wiring metal, a polishing composition ensuring that etching and erosion are suppressed and the residual wiring metal on the portion other than wiring is decreased, is provided, in which a polishing composition comprising (A) an azole group-containing compound having 3 or more azole groups within the molecule and a molecular weight of 300 to 15,000, (B) an oxidant, and (C) one, two or more acids selected from the group consisting of an amino acid, an organic acid and an inorganic acid is provided.

## Description

### TECHNICAL FIELD

The present invention relates to a polishing composition for polishing a substrate. More specifically, the present invention relates to a polishing composition for polishing the metal portion of a substrate. The present invention also relates to a polishing method and a method for producing a substrate.

### BACKGROUND ART

With the progress of IC (Integrated Circuit) or LSI (Large Scale Integration) technology, the operation speed or integration scale thereof has increased, and the fabrication of a high-performance microprocessor or a large-capacity memory chip has been achieved. To such technical advancement, microfabrication technology has greatly contributed. One microfabrication technique is a chemical-mechanical polishing method which uses planarization technology. A chemical-mechanical polishing method is used for planarizing an interlayer dielectric film, and a metal plug or the wiring of a multilayer wiring.

As for the wiring, in view of the problem of a wiring delay or the like, attempts have been recently made to use copper or a copper alloy. The method for producing wiring using copper or a copper alloy includes a damascene process of previously forming trenches in an interlayer dielectric film, then forming, if desired, a thin barrier film such as tantalum or tantalum nitride thin barrier film, and stacking copper or a copper alloy thereon. However, the copper or copper alloy tends to be excessively deposited on the top of the interlayer dielectric film, and therefore, the wiring is formed through polishing and removing excess copper or copper alloy while performing the planarization.

Magnetic Random-Access Memory (MRAM) is also attracting attention as a magnetic recording medium. As for MRAM, it is known that a method where bit writing and word writing lines vertically and horizontally crossing a device array are provided for recording information in specific bits out of the array, and selective writing is performed using only on the device positioned at the intersection region thereof (see, for example, Japanese Unexamined Patent Publication No. 10-116490). In this method, metal wiring is formed, and the metal wiring can consist of a conductor layer composed of aluminum, an aluminum alloy, copper or a copper alloy, and a ferromagnetic layer surrounding the conductor layer, such as nickel-iron (Permalloy) layer. If desired, barrier films composed of tantalum, tantalum nitride or the like are thinly formed to sandwich the ferromagnetic layer. This metal wiring is formed by the damascene process, and the excess conductor layer, ferromagnetic layer and barrier film are removed by planarization through polishing.

With regard to such a method for planarization by polishing, a treating method with a polishing composition comprising an abrasive may be considered, but in the case of a treatment with only an abrasive, the copper or copper alloy which is generally soft is damaged by scratches and yield greatly decreases. Since the copper dissolves by an etching agent, a polishing composition comprising an etching agent may be considered. However, such a polishing composition etches not only the projection, but also the recess, failing in planarization, and moreover, causes a dishing phenomenon wherein the metal wiring part is shaved out.

With respect to a metal polishing composition which is used for polishing a metal film composed of copper or a copper alloy and can prevent such a phenomenon, Japanese Unexamined Patent Publication No. 8-83780 discloses a composition comprising hydrogen peroxide, benzotriazole and aminoacetic acid, and if desired, an abrasive. In this composition, the benzotriazole forms a reaction protective film with the oxidized metal film to allow for preferential mechanical polishing of the projection, thereby enhancing the planarity, and at the same time, contributing to low dishing.

Japanese Unexamined Patent Publication No. 9-55363 discloses a metal-polishing composition comprising 2-quinolinecarboxylic acid capable of reacting with copper to produce a copper complex which is somewhat soluble in water and mechanically more fragile than copper. A benzotriazole-comprising metal-polishing composition has an effect on the planarization or dishing, but is disadvantageous in that the polishing speed greatly decreases due to the strong anticorrosive action of benzotriazole. A metal polishing composition using 2-quinolinecarboxylic acid cannot be readily used in industry because 2-quinolinecarboxylic acid is very expensive.

Japanese Unexamined Patent Publication No. 2002-134444 refers to the use of a slurry comprising ceria and a vinylpyrrolidone/vinylimidazole copolymer for the polishing of a metal such as copper. The slurry described in this document essentially relates to polishing of a silica film. However, in practice, polishing of a metal film has not been demonstrated in Examples, and a metal film cannot be polished with such a slurry composition.

Japanese Patent No. 3,130,279 discloses a slurry composition for polishing, comprising an abrasive particle and a polymer electrolyte having an ionic charge different from the electric charge of the abrasive particle. This polymer electrolyte has a molecular weight of about 500 to about 10,000, and the concentration thereof is from about 5 to about 50 wt% based on the abrasive particle. In this document, the polymer electrolyte is caused to bind with the abrasive particle by differentiating the electric charges of the abrasive particle and the polymer electrolyte from each other, and only a part of the abrasive particle is allowed to be coated with the polymer electrolyte by setting the concentration of the polymer electrolyte to about 5 to about 50 wt% based on the abrasive particle. That is, the polymer electrolyte is used only in relation to the abrasive particle, and this document is silent on the use of an azole having high affinity particularly for a metal to be polished. In this document studies have done mainly on the effect regarding the local planarization of a substrate, but the effect of the molecular weight of the polymer electrolyte on dishing has not been.

In recent years, use of a low K material for the interlayer dielectric film has been studied from the standpoint of parasitic capacity of the copper wiring. As for the low κ material, various inorganic or organic materials have been developed, but those having a dielectric constant on the order of less than 2.3 are required as the next-generation low κ material. In order to achieve such a dielectric constant, the low κ material must be porous. According to Saishin CMP Process to Zairyo Gijutsu (Latest CMP Process and Material Technology), page 133, Technical Information Institute Co., Ltd. (2002), such a material is weak in mechanical strength and is disadvantageously fractured under conventionally employed CMP polishing pressure, and therefore polishing at a low pressure is necessary. However, in the conventional techniques described above, high-pressure polishing is envisaged and high-speed polishing at low pressure has not been studied.

Furthermore, recently wiring tends to be thin. Thus, when thin wirings are present at a high density, occurs in which a barrier film and interlayer dielectric film are polished to produce a depression a phenomenon called erosion. Similar to dishing, erosion gives rise to not only reduction in the wiring resistance, but also a short-circuit, and therefore it is necessary to suppress this phenomenon.

In the polishing of a wiring metal, when a residual wiring metal is present on a portion other than the wiring, for example, on the barrier film, the performance of the slurry for polishing the barrier film may be limited. Accordingly, it is necessary that a residual wiring metal is not present on the barrier film.

### DISCLOSURE OF THE INVENTION

An object of the present invention is to provide a polishing composition ensuring that etching and erosion are suppressed, and particularly that polishing can be performed at a high speed while maintaining the planarity of a metal film, and a residual wiring metal is not present on the portion other than the wiring, for example, on the barrier film. Another object of the present invention is to provide a method for polishing a metal film, using the polishing composition, and a method for producing a substrate, comprising a step of planarization with use of the polishing composition.

As a result of intensive studies to attain these objects, the present inventors have found that these problems can be solved by a polishing composition using an azole group-containing compound having 3 or more azole groups and a mass average molecular weight (hereinafter simply referred to as a "molecular weight") of 300 to 15,000. The present invention has been accomplished based on this finding, i.e., the present invention is set forth as follows:
<1> A polishing composition comprising:
   (A) an azole group-containing compound having 3 or more azole groups within the molecule and having a molecular weight of 300 to 15,000,
   (B) an oxidant, and
   (C) one, two or more acids selected from the group consisting of an amino acid, an organic acid and an inorganic acid.
<2> The polishing composition as described in <1> above, wherein the molecular weight of the azole group-containing compound is from 2,000 to 8,000.
<3> The polishing composition as described in <1> or <2> above, wherein the azole group-containing compound is a polymer containing an azole unit having a vinyl group.
<4> The polishing composition as described in any one of <1> to <3> above, wherein the content of the azole group-containing compound is from 0.001 to 1 mass%.
<5> The polishing composition as described in any one of <1> to <4> above, wherein the molecular weight per one azole group of the azole group-containing compound is from 90 to 300.
<6> The polishing composition as described in any one of <1> to <5> above, wherein the polishing composition further comprises an abrasive.
<7> The polishing composition as described in <6> above, wherein the content of the abrasive is 30 mass% or less.
<8> The polishing composition as described in any one of <1> to <7> above, wherein the polishing composition further comprises an alkyl aromatic sulfonic acid having a carbon number of 8 or more.
<9> The polishing composition as described in <8> above, wherein the content of the alkyl aromatic sulfonic acid is 0.5 mass% or less.
<10> The polishing composition as described in any one of <1> to <9> above, wherein the polishing composition further comprises a phosphoric ester with an alkyl group having a carbon number of 8 or more.
<11> The polishing composition as described in <10> above, wherein the content of the phosphoric ester with an alkyl group having a carbon number of 8 or more is 0.5 mass% or less.
<12> The polishing composition as described in any one of <1> to <11> above, wherein the polishing composition further comprises a fatty acid having a carbon number of 8 or more.
<13> The polishing composition as described in <12> above, wherein the content of the fatty acid is 0.5 mass% or less.
<14> The polishing composition as described in any one of <1> to <13> above, wherein the polishing composition further comprises an anticorrosion agent.
<15> The polishing composition as described in <14> above, wherein the content of the anticorrosion agent is 0.5 mass% or less.
<16> The polishing composition as described in any one of <1> to <15> above, wherein the polishing composition further comprises an alkali.
<17> The polishing composition as described in any one of <1> to <16> above, wherein the pH is from 5 to 11.
<18> The polishing composition as described in any one of <1> to <17> above, wherein the polishing composition further comprises a nonionic water-soluble polymer.
<19> The polishing composition as described in <18> above, wherein the nonionic water-soluble polymer is a polymer of vinyl alcohol, vinylpyrrolidone, acryloylmorpholine or N-isopropylacrylamide, or a copolymer of a combination thereof.
<20> The polishing composition as described in <18> or <19> above, wherein the content of the nonionic water-soluble polymer is 5 mass% or less.
<21> The polishing composition as described in any one of <18> to <20> above, wherein the molecular weight of the nonionic water-soluble polymer is from 3,000 to 100,000.
<22> The polishing composition as described in any one of <1> to <21> above, wherein the polishing composition is used for polishing a metal film embedded in and covering a recess on a substrate, or for polishing a barrier metal film formed on a substrate having a recess and a metal film embedded in and covering the recess.
<23> A method for polishing a substrate, wherein the method comprises planarizing, with use of the polishing composition described in any one of <1> to <21> above, a metal film embedded in and covering a recess on a substrate, or a barrier metal film formed on a substrate having a recess and a metal film embedded in and covering the recess.
<24> The method for polishing a substrate as described in <23> above, wherein the planarization is performed with the temperature of the polishing composition set to 30 to 50°C.
<25> The method for polishing a substrate as described in <23> or <24> above, wherein the metal film is copper or a copper-containing alloy film.
<26> The method for polishing a substrate as described in any one of <23> to <25> above, wherein the barrier metal film is tantalum or a tantalum alloy film.
<27> A method for producing a substrate, wherein the method comprises polishing a substrate by the polishing method described in any one of <23> to <26> above.
<28> A composition which becomes the polishing composition described in any one of <4>, <7>, <9>, <11>, <13> and <15> above when diluted.
<29> A method for using the composition described in <28> above as a composition for transportation or storage.
<30> A kit comprising a plurality of compositions, which form the polishing composition described in any one of <1> to <22> above when the compositions are mixed or mixed and diluted.
<31> A method for using the kit described in <30> above as compositions for transportation or storage.

In the polishing of a metal film, and in particular a copper film, the azole group-containing compound enables a reduction in the dishing. Also, the azole group-containing compound enables the control of removal rate of the barrier film, and erosion can be suppressed. By incorporating this azole group-containing compound, preferably a vinylimidazole polymerization product, into the polishing composition, dishing can reduced without allowing the presence of a residual wiring metal on the barrier film.

Furthermore, production of a substrate with excellent planarity is facilitated by the polishing method and the method for producing a substrate of the present invention, wherein the present a polishing composition comprising an azole group-containing compound having 3 or more azole groups and a molecular weight of 300 to 15,000 is used.

The embodiment of the present invention is described in detail below.

### BRIEF DESCRIPTION OF THE DRAWINGS

Fig. 1 is a transverse cross-sectional view for explaining the polishing process of a patterned wafer.
Fig. 2 is a transverse cross-sectional view for explaining the dishing.
Fig. 3 is a transverse cross-sectional view for explaining the erosion.

### BEST MODE FOR CARRYING OUT THE INVENTION

The present invention relates to a polishing composition which comprises an azole group-containing compound having 3 or more azole groups within the molecule and having a molecular weight of 300 to 15,000, an oxidant; one, two or more acids selected from the group consisting of an amino acid, an organic acid and an inorganic acid; and an optional abrasive. The polishing composition is preferably used for the polishing of a metal film.

### <Azole Group-Containing Compound>

The azole group-containing compound having 3 or more azole groups within the molecule and having a molecular weight of 300 to 15,000, used in the present invention, is an azole group-containing compound having 3 or more azole groups within one molecule and can be produced by various methods. The azole includes imidazole, triazole, tetrazole and thiazole, and these may have a reactive substituent such as hydroxyl group, carboxyl group and amino group. Examples thereof include 4-carboxyl-1H-benzotriazole, 4-hydroxybenzotriazole, and 2-aminoimidazole. Out of the reactive substituents, the carboxyl group reacts with a polyhydric alcohol or a polyvalent amine to produce an ester or an amide, respectively. At this time, when a trivalent or greater compound is used as the polyhydric alcohol or polyvalent amine, a compound having 3 or more azole groups can be produced. Similarly, the compound having 3 or more azole groups can be produced from an azole having a hydroxyl group or an amino group through a reaction with a compound having a moiety which reacts with such a substituent.

The azole group-containing compound for use in the present invention can also be produced by polymerizing an azole having a vinyl group. Examples of the azole having a vinyl group include 1-vinylimidazole and 2-[3-(2H-benzotriazol-1-yl)-4-hydroxyphenyl]ethyl methacrylate.

Among these azole group-containing compounds, a polymer containing an azole unit having a vinyl group is preferred. This polymer is obtained by polymerizing an azole having a vinyl group. The azole having a vinyl group may be polymerized alone or may be copolymerized with another vinyl compound.

Specifically, the azole group-containing compound may be synthesized such that the molecular weight per one azole group of the azole group-containing compound becomes from 90 to 300, preferably from 90 to 200.

Examples of the vinyl compound which can be copolymerized with the azole having a vinyl group include acrylic acid, methacrylic acid, methyl acrylate, methyl methacrylate, acrylamide, N-vinylacetamide, N-vinylformamide, acryloylmorpholine, N-vinylpyrrolidone, vinyl acetate and styrene.

The polymerization method of such a vinyl compound is generally radical polymerization in an aqueous solution or an organic solvent. The polymerization is performed by using a radical initiator such as azobisisobutyronitrile, and the molecular weight may be adjusted by a chain transfer agent such as dodecylmercaptane, trimethylolpropane tris(3-mercaptopropionate) and α-methylstyrene dimer.

The molecular weight of the polymerization product which can be used is, in terms of the mass average molecular weight, from 300 to 15,000, preferably from 500 to 10,000, more preferably from 2,000 to 8,000, and still more preferably from 4,500 to 6,500.

In the polishing composition of the present invention, the content of the azole group-containing compound may be from 0.001 to 1 mass%, preferably from 0.002 to 0.5 mass%, more preferably from 0.003 to 0.1 mass%. If the compound is added in a small amount, the effect of suppressing the etching or increasing the polishing speed is small, whereas if added in a large amount, the effect of the large amount addition is small and, depending on circumstances, aggregation of the abrasive added may be promoted.

The polishing composition of the present invention may be used as an organic solvent composition, an organic solvent/water-mixed composition or an aqueous composition, but in view of cost, usability and the like, the polishing composition is preferably an aqueous solution. For this purpose, the azole group-containing compound for use in the present invention is also preferably water-soluble. For the production of the polishing composition of the present invention, a stock solution in a high concentration may be prepared, and then diluted to prepare the polishing composition of the present invention. Accordingly, the azole group-containing compound for use in the present invention preferably has a solubility of 0.01 mass% or more, more preferably 0.03 mass% or more, in water.

The azole group for use in the present invention is known to interact with a metal such as copper, and this is considered to enhance the step height reduction ability and dishing characteristics. Also, the azole group-containing compound for use in the present invention enables the control of removal rate of the barrier film such as tantalum and it is considered that the ability contributes to the improvement of erosion characteristics. On the other hand, a basic compound such as ethanolamine generally used for controlling the removal rate of the barrier film, like the azole group-containing compound, improves the erosion characteristics but rather worsen the step height reduction ability or dishing characteristics. The present invention uses an azole group-containing compound having 3 or more azole groups and a molecular weight of 300 to 15,000, and thereby seemingly enables the polishing composition to have the contradictory functions at the same time through a complex effect, that is a function of step height reduction, a function of the dishing character improvement and a function of the erosion character improvement. Incidentally, when polishing of a wiring metal, an azole group-containing compound having 3 or more azole group and a molecular weight of more than 15,000 tends to leave a residual metal on the portion other than wiring, for example on the barrier film, and the usage of the barrier film polishing slurry may be limited.

### <Acid>

The acid contained in the polishing composition of the present invention, which is selected from the group consisting of an inorganic acid, an organic acid and an amino acid, can be added as an etching agent to promote the polishing and at the same time, to perform stable polishing. The inorganic acid includes sulfuric acid, phosphoric ester, phosphonic acid and nitric acid. The organic acid includes a carboxylic acid such as formic acid, acetic acid, propionic acid, butyric acid, valeric acid, 2-methylbutyric acid, n-hexanoic acid, 3,3-dimethylbutyric acid, 2-ethylbutyric acid, 4-methylpentanoic acid, n-heptanoic acid, 2-methylhexanoic acid, n-octanoic acid, 2-ethylhexanoic acid, benzoic acid, glycolic acid, salicylic acid, glyceric acid, oxalic acid, malonic acid, succinic acid, glutaric acid, adipic acid, pimelic acid, maleic acid, phthalic acid, malic acid, tartaric acid, citric acid and lactic acid, and a salt thereof. The amino acid includes an amino acid such as glycine, L-alanine, β-alanine, L-2-aminobutyric acid, L-norvaline, L-valine, L-leucine, L-norleucine, L-isoleucine, L-alloisoleucine, L-phenylalanine, L-proline, sarcocine, L-ornithine, L-lysine, taurine, L-serine, L-threonine, L-allothreonine, L-homoserine, L-tyrosine, 3,5-diiodo-L-tyrosine, β-(3,4-dihydroxyphenyl)-L-alanine, L-thyroxine, 4-hydroxy-L-proline, L-cystine, L-methionine, L-ethionine, L-lanthionine, L-cystathionine, L-cystine, L-cysteic acid, L-aspartic acid, L-glutamic acid, S-(carboxymethyl)-L-cysteine, 4-aminobutyric acid, L-asparagine, L-glutamine, azaserine, L-arginine, L-canavanine, L-citrulline, δ-hydroxy-L-lysine, creatine, L-kynurenine, L-histidine, 1-methyl-L-histidine, 3-methyl-L-histidine, ergothioneine and L-tryptophane.

The polishing composition may comprise one of these acids such as inorganic acid, organic acid and amino acid, or may comprise two or more species thereof. The content of the acid may be from 0.01 to 10 mass%, preferably from 0.02 to 5 mass%, more preferably from 0.05 to 2 mass%, based on the polishing composition. If the content is too small, high polishing speed cannot be obtained, whereas if the content is excessively large, etching of a metal, metal alloy or the like may proceed at an excessively high speed.

### <Oxidant>

The oxidant for use in the polishing composition of the present invention oxidizes a metal, metal alloy or the like and thereby, contributes to the enhancement of polishing speed. Examples of the oxidant include oxygen: ozone; hydrogen peroxide; an alkyl peroxide such as tert-butyl hydroperoxide and ethylbenzene hydroperoxide; a peracid such as peracetic acid and perbenzoic acid; a permanganate such as potassium permanganate; a periodate such as potassium periodate; a persulfate such as ammonium persulfate and potassium persulfate; a hypochlorite such as potassium hypochlorite; and a polyoxoacid. Among these oxidants, hydrogen peroxide and persulfate are preferred in view of easy handleability.

The content of the oxidant may be from 0.01 to 30 mass%, preferably from 0.05 to 20 mass%, more preferably from 0.1 to 10 mass%, based on the polishing composition. If the oxidant content is too small, the polishing speed may become too low, whereas if it is excessively large, not only this is not effective, but also the polishing speed may be reduced.

### <Abrasive>

The abrasive which can be used in the polishing composition of the present invention includes silica, alumina, ceria and an organic abrasive. The polishing composition may comprise one of these abrasives or may comprise two or more thereof. The purpose of such an abrasive is to sufficiently increase the polishing speed, but depending on the kind of the abrasive, damage such as scratch may occur on the substrate surface. As for the abrasive capable of reducing the damage while providing a sufficient polishing speed, silica is preferred, and an abrasive mainly comprising colloidal silica produced by the hydrolysis from alkoxysilane is more preferred. The content of the abrasive may be from 0.01 to 30 mass%, preferably from 0.1 to 20 mass%, more preferably from 0.2 to 10 mass%, based on the polishing composition. If the content of the abrasive is excessively large, dishing or scratches may be caused, whereas if the content is too small, a sufficient polishing speed cannot be obtained or the residual metal film on the barrier film may not be eliminated. As for the size of the abrasive, the particle diameter is preferably 1 µm or less, more preferably from 0.01 to 0.5 µm. If the particle diameter of the abrasive is too small, the sufficient polishing speed may not be obtained, whereas if it is excessively large, a damage such as scratch may occur on the metal surface.

### <Other Components>

The polishing composition of the present invention may further comprise an alkyl aromatic sulfonic acid having a carbon number of 8 or more. This alkyl aromatic sulfonic acid includes an alkylbenzenesulfonic acid such as decylbezenesulfonic acid, undecylbenzenesulfonic acid, dodecylbenzenesulfonic acid, tridecylbenzenesulfonic acid, tetradecylbenzenesulfonic acid, and a mixture thereof; an alkylnaphthalenesulfonic acid; and a formalin condensate of alkylnaphthalenesulfonic acid. The alkyl aromatic sulfonic acid having a carbon number of 8 or more may be in the form of a salt such as potassium or ammonium. Among these aromatic sulfonic acids, dodecylbenzenesulfonic acid is preferred. The polishing composition may comprise one of these alkyl aromatic sulfonic acids having a carbon number of 8 or more, or may comprise two or more thereof. The content of the alkyl aromatic sulfonic acid having a carbon number of 8 or more may be 5 mass% or less, preferably 1 mass% or less, more preferably 0.5 mass% or less, based on the polishing composition. The alkyl aromatic sulfonic acid having a carbon number of 8 or more is considered to contribute to the step height reduction of a metal film.

The polishing composition of the present invention may further comprise a phosphoric ester with an alkyl group having a carbon number of 8 or more. The phosphoric ester includes an alkylphosphoric ester such as octyl phosphoric ester, decyl phosphoric ester, lauryl phosphoric ester, myristyl phosphoric ester, cetyl phosphoric ester, stearyl phosphoric ester, secondary alkyl (average carbon number: 13) phosphoric ester, 2-ethylhexyl phosphoric ester and oleyl phosphoric ester; and a polyoxyalkylene ether alkylphosphoric ester such as monostearyl glyceryl ether phosphoric ester, monocetyl glyceryl ether phosphoric ester, monooleyl glyceryl ether phosphoric ester, isostearyl glyceryl ether phosphoric ester, polyoxyethylene octyl ether phosphoric ester, polyoxyethylene decyl ether phosphoric ester, polyoxyethylene lauryl ether phosphoric ester, polyoxyethylene myristyl ether phosphoric ester, polyoxyethylene cetyl ether phosphoric ester, polyoxyethylene stearyl ether phosphoric ester, polyoxyethylene secondary alkyl (average carbon number: 13) ether phosphoric ester, polyoxyethylene 2-ethylhexyl ether phosphoric ester, polyoxyethylene 2-oleyl ether phosphoric ester and polyoxyethylene nonylphenyl ether phosphoric ester. Such a phosphoric ester may be in the form of a salt such as potassium or ammonium salt, or may be a primary, secondary or tertiary ester or a mixture thereof. Among these, an alkylphosphoric ester having a carbon number of 8 to 18 is preferred, such as octyl phosphoric ester, lauryl phosphoric ester and stearyl phosphoric ester; and a polyoxyalkylene ether phosphoric ester such as polyoxyethylene lauryl ether phosphoric ester and polyoxyethylene secondary alkyl (average carbon number: 13) ether phosphoric ester, and more preferred is a polyoxyalkylene ether phosphoric ester having a carbon number of 10 to 15.

Regarding the phosphoric ester with an alkyl group having a carbon number of 8 or more for use in the present invention, one, two or more species may be contained. The content of such a compound may be 5 mass% or less, preferably 1 mass% or less, more preferably 0.5 mass% or less, based on the polishing composition. Such a phosphoric ester or polyoxyalkylene ether phosphoric ester exerts an effect of suppressing the dishing, but if the content thereof is small, the effect of suppressing the dishing is low, whereas if the compound is added in a large amount, the dishing may be reduced, but in view of practical performance, the polishing composition is cannot be usable in a field where a high polishing speed is required.

The polishing composition of the present invention may further comprise a fatty acid having a carbon number of 8 or more. The fatty acid having a carbon number of 8 or more reduces the surface roughening of a metal film during polishing, by itself or in combination with, for example, the azole group-containing compound having 3 or more azole groups within the molecule and a molecular eight of 300 to 15,000. The fatty acid having a carbon number of 8 or more includes a saturated fatty acid such as caprylic acid, pelargonic acid, capric acid, lauric acid, myristic acid, pentadecylic acid, palmitic acid, margarinic acid, stearic acid, arachic acid, behenic acid, lignoceric acid, cerotic acid, montanic acid and melissic acid; and an unsaturated fatty acid such as eicosapentaenoic acid, oleic acid, linoleic acid and linolenic acid. These fatty acids may be in the form of a salt such as potassium or ammonium salt, and the polishing composition may comprise one, two or more thereof. Among these, oleic acid is preferred. The oleic acid may be used as oleic acid alone or as a fatty acid mixture comprising 50 mass% or more oleic acid. The content of the fatty acid having a carbon number of 8 or more may be 5 mass% or less, preferably 1 mass% or less, more preferably 0.5 mass% or less. If the fatty acid content is too small, the surface roughening of a metal film cannot be prevented, whereas if the content is excessively large, a residual metal film on the barrier film may result.

To the polishing composition of the present invention, a water-soluble polymer or a surfactant may be further added.

The water-soluble polymer includes polyacrylic acid, polymethacrylic acid, an ammonium salt thereof, polyisopropylacrylamide, polydimethylacrylamide, polymethacrylamide, polymethoxyethylene, polyvinyl alcohol, hydroxyethyl cellulose, carboxymethyl cellulose, carboxyethyl cellulose, polyvinylpyrrolidone, polyvinylcaprolactam and polyacryloylmorpholine. Such a water-soluble polymer may be added within the range not affecting the performance. From the standpoint of preventing the corrosion of metal surface, the water-soluble polymer is preferably a nonionic water-soluble polymer having an amide group, an alcoholic hydroxyl group, methoxy, ethoxy or the like. More preferably, a nonionic water-soluble polymer is the one having a cyclic amide, an N-alkyl-substituted amide group or an alcoholic hydroxyl group. The nonionic water-soluble polymer is still more preferably polyvinyl alcohol, polyvinylpyrrolidone, polyacryloylmorpholine or poly-N-isopropylacrylamide. A copolymer thereof may also be used. Examples thereof include a copolymer of N-isopropylacrylamide and vinylpyrrolidone, a copolymer of N-isopropylacrylamide and acryloylmorpholine, and a copolymer of vinylcaprolactam and vinylpyrrolidone.

As for the surfactant, any of cationic, anionic and nonionic surfactants may be used. Examples of the cationic surfactant include an aliphatic amine or a salt thereof, and an aliphatic ammonium salt. Examples of the anionic surfactant include an alkyl ether carboxylic acid or a salt thereof, and a sulfuric ester compound such as higher alcohol sulfuric ester and alkyl ether sulfuric acid or a salt thereof. The nonionic surfactant includes an ether type such as polyoxyethylene alkyl ether; an ether ester type such as polyoxyethylene ether of glycerin ester; and an ester type such as polyethylene glycol fatty acid ester, glycerin ester and sorbitan ester.

The content of the water-soluble polymer or surfactant is preferably 5 mass% or less, more preferably 1 mass% or less, still more preferably 0.5 mass% or less, based on the polishing composition.

The polishing composition of the present invention may further comprise an anticorrosion agent (protective film-forming agent). This component is preferably an azole such as benzimidazole-2-thiol, 2-[2-(benzothiazolyl)]thiopropionic acid, 2-[2-(benzothiazolyl)]thiobutyric acid, 2-mercaptobenzothiazole, 1,2,3-triazole, 1,2,4-triazole, 3-amino-1H-1,2,4-triazole, benzotriazole, 1-hydroxybenzotriazole, 1-dihydroxypropylbenzotriazole, 2,3-dicarboxypropylbenzotriazole, 4-hydroxybenzotriazole, 4-carboxyl-1H-benzotriazole, 4-methoxycarbonyl-1H-benzotriazole, 4-butoxycarbonyl-1H-benzotriazole, 4-octyloxycarbonyl-1H-benzotriazole, 5-hexylbenzotriazole, N-(1,2,3-benzotriazolyl-1-methyl)-N-(1,2,4-triazolyl-1-methyl)-2-ethylhexylamine, tolyltriazole, naphthotriazole, bis[(1-benzotriazolyl)methyl]phosphonic acid, benzimidazole, and tetrazole; or a salt thereof. The component is more preferably benzotriazole, tolyltriazole, hydroxybenzotriazole, carboxybenzotriazole, benzimidazole, tetrazole or quinaldinic acid. The content of the anticorrosion agent may be 5 mass% or less, preferably 2 mass% or less, more preferably 0.5 mass% or less, based on the polishing composition. Such an anticorrosion agent is effective for preventing roughening of the metal film surface.

In the polishing composition of the present invention, an alkali may be added within a range not adversely affecting the performance and physical properties. The alkali is used for the purpose of maintaining the stable polishing performance or used as a pH adjusting agent or a buffering agent. The alkali includes ammonia; sodium hydroxide; potassium hydroxide; potassium carbonate; potassium bicarbonate; ammonium bicarbonate; an alkyl monoamine such as methylamine, ethylamine, propylamine, isopropylamine, butylamine, isobutylamine, tert-butylamine, amylamine, allylamine, 2-ethylhexylamine, cyclohexylamine, benzylamine and furfurylamine; a hydroxyl group-containing monoamine such as O-aminophenol, ethanolamine, 3-amino-1-propanol and 2-amino-1-propanol; a diamine such as ethylenediamine, diethylenetriamine, triethylenetetramine, tetraethylenepentamine, pentaethylenehexamine, O-phenylenediamine, trimethylenediamine, 2,2-diamino-di-n-propylamine, 2-methyl-2-(2-benzylthioethyl)ethylenediamine, 1,5-diamino-3-pentanol, 1,3-diamino-2-propanol, xylenediamine and bisaminopropylpolyalkylene ether; and a polyamine such as polyallylamine and polyethyleneimine. Among these alkalis, ammonia and potassium hydroxide are preferred. The amount of the alkali added may be 10 mass% or less, preferably 5 mass% or less, more preferably 1 mass% or less, based on the polishing composition.

### <Use of Polishing Composition>

The polishing composition of the present invention may be used at a pH of 2 to 12, preferably from 3 to 11, more preferably from 5 to 10. Regarding the reagent for adjusting the pH to such a range, the inorganic acid, the organic acid or the alkali described above may be used.

The polishing composition of the present invention may be preferably used at 0 to 100°C. Generally, the temperature of the polishing composition is preferably near room temperature, but the temperature may be adjusted for the purpose of controlling the polishing speed and like. If the temperature is too low, the polishing speed will not increase, and the polishing composition may freeze at 0°C or less, whereas if the temperature is high, a side reaction may occur. The temperature of the polishing composition is preferably from 10 to 50°C, more preferably from 15 to 40°C.

The amount of the polishing composition of the present invention added dropwise to a polishing machine is determined by the polishing machine and size of the wafer. In the case of using a 8-inch wafer (200-mm wafer), the polishing composition may be used at 10 to 1,000 ml/min, preferably from 50 to 500 ml/min, more preferably from 100 to 400 ml/min.

A material to be polished, to which the polishing composition of the present invention is preferably applied, includes a metal. Specific preferred examples of the metal include aluminum, copper, iron, tungsten, nickel, tantalum, a platinum group metal (e.g., ruthenium, platinum), and an alloy of such a metal. Particularly, A material to be polished is a wiring portion of a multilayer wiring, or a metal layer covering the wiring portion and embedded in a recess on a substrate. The polishing composition may be more preferably used for copper, a copper alloy, iron or an iron alloy forming a wiring portion of a multilayer wiring part. Incidentally, a barrier film may be provided between the wiring metal film and the substrate and in this case, the barrier film can be polished together with the metal film. Preferred examples of the material used for the barrier film include tantalum, a tantalum alloy, tantalum nitride, titanium and a titanium alloy.

The polishing method using the polishing composition of the present invention includes a method of pressing, for example, a substrate having thereon a metal film to be polished against an abrasive cloth and in this state, polishing the metal film to be polished by causing relative movement between the polishing platen and the substrate while supplying the polishing composition of the present invention onto the abrasive cloth of the polishing platen. As for the polishing apparatus, a general polishing apparatus comprising a holder for holding a semiconductor substrate and a platen having attached thereon an abrasive cloth may be used. The rotation speed of the polishing platen greatly differs according to the structure and size of the polishing machine and is difficult to specify here, but the polishing is performed at 10 to 500 m/min, preferably from 20 to 300 m/min, more preferably from 30 to 150 m/min. During polishing of a substrate by the rotation of the polishing platen, the substrate must be rotated so as to keep the uniformity of polishing. The rotation speed of the substrate is nearly the same as that of the polishing platen but is sometimes slightly decreased or increased for achieving the uniformity of polishing. The substrate is pressed against the polishing cloth by applying a pressure through the holder and at this time, the pressure may be from 0.1 to 100 kPa. The pressure tends to be low when the rotation speed of the polishing platen is high, and is difficult to specify but is preferably from 0.5 to 80 kPa, more preferably 1 to 50 kPa.

Regarding the polishing cloth, for example, a nonwoven fabric or polyurethane foam may be used. In most polishing cloths, a groove is provided for the purpose of increasing the polishing speed or achieving smooth discharge of a slurry. Examples thereof include an XY groove and a K groove, and the polishing composition of the present invention is applicable to any of these grooves. Also, the polishing cloth is dressed by a dresser with a diamond or the like so as to prevent clogging and maintain stable polishing, and a generally known dressing method may be used.

Regarding the method for supplying the polishing composition of the present invention onto the polishing cloth of the polishing platen, the polishing composition is continuously supplied by use of a pump or the like. At this time, the polishing composition may be supplied as one solution containing all components. Furthermore, in consideration of stability of the solution, a solution containing hydrogen peroxide and a solution containing other components may be supplied from separate lines. In the case of supplying two or more solutions from separate lines, the solutions may be supplied by combining them into one solution immediately before the polishing cloth, or may be directly supplied onto the polishing cloth from separate lines.

Considering handling convenience such as stability of the solution, the polishing composition of the present invention may be divided into a plurality of compositions during the transportation or storage, and/or stored as a thick composition. For example, the polishing composition is divided into two compositions, i.e., a solution containing the oxidant and a solution containing others. Furthermore, in the case of containing an abrasive grain as the abrasive, the polishing composition may be divided into three kinds of compositions in total by further separating a solution mainly comprising the abrasive. Also, the polishing composition of the present invention may be prepared as a polishing composition thicker than in use, and used at the polishing by diluting it with water or the like to a concentration suitable for polishing. For example, a composition from 2 to 5-times thicker than in use may be prepared. The compositions divided as above may be combined to constitute a kit which forms the polishing composition of the present invention when the divided compositions are mixed, and if desired, diluted.

A substrate having a planarized metal film can be produced by such a polishing method. This process is further described by referring to the method of forming a wiring on a device. First, trenches and openings for wiring are formed on an interlayer dielectric film on a substrate, and a thin barrier film is formed on the dielectric film. Furthermore, a metal film for metal wiring, such as copper, is formed by plating or the like to fill the trenches and openings. This metal film is polished and, if desired, the barrier film and the interlayer dielectric film are further planarized by polishing, whereby a substrate having a planarized metal film can be produced. The method for forming wiring in MRAM is described below. The metal wiring comprises a conductor layer composed of aluminum, an aluminum alloy, copper or a copper alloy; and a ferromagnetic layer surrounding the conductor layer, such as nickel-iron (Permalloy). If desired, barrier films composed of tantalum, tantalum nitride or the like are thinly formed to sandwich the ferromagnetic layer. This metal wiring is formed by the damascene process, and the excess conductor layer, ferromagnetic layer and barrier film are removed by planarization polishing.

The interlayer dielectric film as used herein indicates a silicon oxide film; an inorganic interlayer dielectric film containing a large amount of silicon such as hydroxysilsesquioxane (HSQ) and methylsilsesquioxane (MSQ); or an organic interlayer dielectric film such as benzocyclobutene film. A low-dielectric-constant interlayer dielectric film obtained by incorporating pores into such a interlayer dielectric film may also be used.

### EXAMPLES

The present invention is described in greater detail below by referring to Examples, but the present invention is not limited to these Examples.

### <<Synthesis Example>>

Synthesis examples of the azole group-containing compound having 3 or more azole groups (Compounds A to G), and synthesis examples of the nonionic water-soluble polymer (Compounds H and I) are set forth below, but the present invention is not limited to these synthesis examples.

### <Compound A>

After charging 40 g of 2-propanol into a 500 ml-volume flask equipped with a thermometer, a stirring device, a nitrogen inlet tube and a reflux condenser, it was heated to the temperature of 75°C while it was stirred under a nitrogen atmosphere. Subsequently, a solution obtained by dissolving 46.31 g of 1-vinylimidazole and 43.69 g of 1-vinylpyrrolidone in 78 g of 2-propanol (hereinafter referred to as a "monomer solution"), and a solution obtained by dissolving 4.08 g of dimethyl 2,2'-azobis(2-methylpropionate) in 163.92 g of 2-propanol (hereinafter referred to as an "initiator solution 1") each was added thereto through a metering pump. The addition was performed over 4 hours for the monomer solution and 6 hours for the initiator solution 1. After the addition of the initiator solution, the reaction solution was heated to the refluxing temperature (about 83°C). Furthermore, a solution obtained by dissolving 2.04 g of dimethyl 2,2'-azobis(2-methylpropionate) in 38.76 g of 2-propanol (hereinafter referred to as an "initiator solution 2") was added, and then the reaction was continued for 7.5 hours. The reaction solution was then cooled to room temperature, as a result, about 415 g of a clear brown solution was obtained. An operation of concentrating this clear brown solution in a rotary vacuum evaporator and dissolving it in water was repeated twice, whereby the 2-propanol solvent was replaced with water. The solid content concentration was 15%, and the compound was directly used for the preparation of a slurry without isolation.

### <Compound B>

After charging 30 g of 2-propanol into a 500 ml-volume flask equipped with a thermometer, a stirring device, a nitrogen inlet tube and a reflux condenser, it was heated to the refluxing temperature (about 83°C) while it was stirred under a nitrogen atmosphere. Subsequently, a solution obtained by dissolving 46.31 g of 1-vinylimidazole, 43.69 g of 1-vinylpyrrolidone and 0.84 g of α-methylstyrene dimer in 77.2 g of 2-propanol (hereinafter referred to as a "monomer solution"), and a solution obtained by dissolving 3.26 g of dimethyl 2,2'-azobis(2-methylpropionate) in 164.74 g of 2-propanol (hereinafter referred to as an "initiator solution 1") each was added thereto through a metering pump. The addition was performed over 4 hours for both solutions. After the addition of the monomer solution and initiator solution 1, the reaction was continued for 1 hour. Furthermore, a solution obtained by dissolving 0.82 g of dimethyl 2,2'-azobis(2-methylpropionate) in 15.58 g of 2-propanol (hereinafter referred to as an "initiator solution 2") was added. An operation of adding the same initiator solution 2 every one hour of reaction (initiator additional addition operation) was repeated three times, and then the reaction was further continued for 4 hours. The reaction solution was then cooled to room temperature, as a result, about 420 g of a clear brown solution was obtained. An operation of concentrating this clear brown solution in a rotary vacuum evaporator and dissolving it in water was repeated twice, whereby the 2-propanol solvent was replaced with water. The solid content concentration was 15%, and the compound was directly used for the preparation of a slurry without isolation.

### <Compound C>

After charging 30 g of n-propanol into a 500 ml-volume flask equipped with a thermometer, a stirring device, a nitrogen inlet tube and a reflux condenser, it was heated to the refluxing temperature (about 98°C) while it was stirred under a nitrogen atmosphere. Subsequently, a solution obtained by dissolving 15.72 g of 1-vinylimidazole, 74.28 g of 1-vinylpyrrolidone and 0.066 g of 2-mercaptoethanol in 29.93 g of n-propanol (hereinafter referred to as a "monomer solution"), and a solution obtained by dissolving 0.77 g of dimethyl 2,2'-azobis(2-methylpropionate) in 215.23 g of n-propanol (hereinafter referred to as an "initiator solution 1") each was added thereto through a metering pump. The addition was performed over 4 hours for both solutions. After the addition of the monomer solution and initiator solution 1, the reaction was continued for 1 hour. Furthermore, a solution obtained by dissolving 0.77 g of dimethyl 2,2'-azobis(2-methylpropionate) in 14.63 g of n-propanol (hereinafter referred to as an "initiator solution 2") was added, and then the reaction was further continued for 5 hours. The reaction solution was then cooled to room temperature, as a result, about 380 g of a clear brown solution was obtained. An operation of concentrating this clear brown solution in a rotary vacuum evaporator and dissolving it in water was repeated twice, whereby the 2-propanol solvent was replaced with water. The solid content concentration was 15%, and the compound was directly used for the preparation of a slurry without isolation.

### <Compound D>

This compound was synthesized in the same manner as Compound C, except that the monomer solution was a solution obtained by dissolving 46.31 g of 1-vinylimidazole, 43.69 g of 1-vinylpyrrolidone and 0.21 g of 2-mercaptoethanol in 29.79 g of n-propanol; the initiator solution 1 was a solution obtained by dissolving 0.82 g of dimethyl 2,2'-azobis(2-methylpropionate) in 215.18 g of n-propanol; the initiator solution 2 was a solution obtained by dissolving 0.82 g of dimethyl 2,2'-azobis(2-methylpropionate) in 15.58 g of n-propanol; and an operation of additionally adding the initiator was repeated twice. The solid content concentration was 18%, and the compound was directly used for the preparation of a slurry without isolation.

### <Compound E>

After charging 40 g of 2-propanol into a 500 ml-volume flask equipped with a thermometer, a stirring device, a nitrogen inlet tube and a reflux condenser, it was heated to the refluxing temperature (about 83°C) while it was stirred under a nitrogen atmosphere. Subsequently, a solution obtained by dissolving 46.31 g of 1-vinylimidazole, 43.69 g of N-vinylpyrrolidone and 1.46 g of α-methylstyrene dimer in 28.5 g of 2-propanol and dissolving the resulting solution in 78 g of 2-propanol (hereinafter referred to as a "monomer solution"), and a solution obtained by dissolving 2.45 g of dimethyl 2,2'-azobis(2-methylpropionate) in 213.55 g of 2-propanol (hereinafter referred to as an "initiator solution 1") each was added thereto through a metering pump. The addition was performed over 4 hours for the monomer solution and 7 hours for the initiator solution 1. After the addition of initiator solution 1, the reaction was continued for 1 hour, and then a solution obtained by dissolving 0.21 g of dimethyl 2,2'-azobis(2-methylpropionate) in 6.59 g of 2-propanol (hereinafter referred to as an "initiator solution 2") was added. An operation of adding the same initiator solution 2 every one hour of reaction (initiator additional addition operation) was repeated five times, and then the reaction was further continued for 4 hours. The reaction solution was then cooled to room temperature, as a result, about 380 g of a clear brown solution was obtained. An operation of concentrating this clear brown solution in a rotary vacuum evaporator and dissolving it in water was repeated twice, whereby the 2-propanol solvent was replaced with water. The solid content concentration was 15%, and the compound was directly used for the preparation of a slurry without isolation.

### <Compound F>

After charging 40 g of 2-propanol into a 500 ml-volume flask equipped with a thermometer, a stirring device, a nitrogen inlet tube and a reflux condenser, it was heated to the refluxing temperature (about 83°C) while it was stirred in a nitrogen atmosphere. Subsequently, a solution obtained by dissolving 46.31 g of 1-vinylimidazole, 43.69 g of N-vinylpyrrolidone and 0.36 g of dodecylmercaptan in 77.6 g of 2-propanol (hereinafter referred to as a "monomer solution"), and a solution obtained by dissolving 1.22 g of dimethyl 2,2'-azobis(2-methylpropionate) in 166.78 g of 2-propanol (hereinafter referred to as an "initiator solution 1") each was added thereto through a metering pump. The addition was performed over 4 hours for the monomer solution and 7 hours for the initiator solution 1. After the addition of initiator solution 1, the reaction was continued for 1 hour, and then a solution obtained by dissolving 0.41 g of dimethyl 2,2'-azobis(2-methylpropionate) in 7.79 g of 2-propanol (hereinafter referred to as an "initiator solution 2") was added. An operation of adding the same initiator solution 2 every one hour of reaction (initiator additional addition operation) was repeated twice, and the reaction was further continued for 4 hours. The reaction solution was then cooled to room temperature. An operation of concentrating this clear brown solution in a rotary vacuum evaporator and dissolving it in water was repeated twice, whereby the 2-propanol solvent was replaced with water. The solid content concentration was 15%, and the compound was directly used for the preparation of a slurry without isolation.

### <Compound G>

This compound was synthesized in the same manner as Compound F, except that the amount of dodecylmercaptan added was 1.00 g. An operation of concentrating the obtained clear brown solution in a rotary vacuum evaporator and dissolving it in water was repeated twice, thereby replacing the solvent with water, and the solution was then purified. The solid content concentration was 14%, and the compound was directly used for the preparation of a slurry without isolation.

### <Compound H>

After charging 55 g of n-propanol, 10 g of acryloylmorpholine, 0.36 g of dimethyl 2,2'-azobis(2-methylpropionate) and 0.08 g of 1-dodecanethiol into a 100 ml-volume flask equipped with a thermometer, a stirring device, a nitrogen inlet tube and a reflux condenser, it was heated to the refluxing temperature (about 98°C) while it was stirred under a nitrogen atmosphere. When 4 hours lapsed at the refluxing temperature, 4.00 g of an n-propanol solution containing 4 mass% of dimethyl 2,2'-azobis(2-methylpropionate) was added thereto, and the mixture was further kept at the refluxing temperature over 4 hours. The reaction solution was then cooled to room temperature, and then the resulting solution was concentrated in a rotary vacuum evaporator and dissolved in water. The concentration and dissolution in water were performed one more time, whereby the n-propanol solvent was replaced with water. The solid content concentration was 5%, and the compound was directly used for the preparation of a slurry without isolation.

### <Compound I>

After charging 55 g of n-propanol, 5.15 g of N-vinylpyrrolidone, 4.85 g of N-isopropylacrylamide, 0.45 g of dimethyl 2,2'-azobis(2-methylpropionate) and 0.10 g of 1-dodecanethiol into a 100 ml-volume flask equipped with a thermometer, a stirring device, a nitrogen inlet tube and a reflux condenser, it was heated to the refluxing temperature (about 98°C) while it was stirred under a nitrogen atmosphere. When 4 hours lapsed at the refluxing temperature, 5.00 g of an n-propanol solution containing 4 mass% of dimethyl 2,2'-azobis(2-methylpropionate) was added, and the mixture was further kept at the refluxing temperature over 4 hours. The reaction solution was then cooled to room temperature, and the resulting solution was concentrated in a rotary vacuum evaporator and dissolved in water. The concentration and dissolution in water were performed one more time, whereby the n-propanol solvent was replaced with water. The solid content concentration was 5%, and the compound was directly used for the preparation of a slurry without isolation.

### <Measurement of Molecular Weight>

The molecular weight of the compound synthesized was measured in polyethylene glycol equivalent by gel permeation chromatography (GPC). In the present invention, a commercially available compound was also used, and this compound was subjected together to the measurement. The commercially available compound used was VPI55K72W (simply referred to as "72W", produced by BASF) which is a 1:1 copolymer of 1-vinylimidazole and 1-vinylpyrrolidone.

The results of the molecular weight measurement of Compounds A to I and 72W are shown below.

| | |
|---|---|
| Compound A: | 10,500 |
| Compound B: | 6,200 |
| Compound C: | 5,500 |
| Compound D: | 5,500 |
| Compound E: | 5,000 |
| Compound F: | 6,100 |
| Compound G: | 1,800 |
| Compound H: | 11,000 |
| Compound I: | 12,000 |
| Compound 72W: | 220,000 |

### <Wafer>

### Blanket wafer: Silicon wafer uniformly coated with copper film and tantalum film (barrier film)

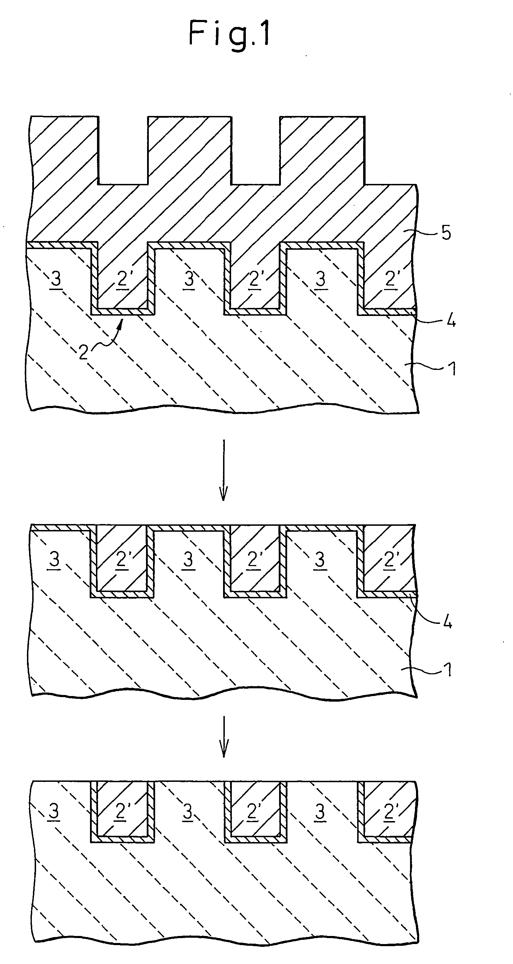

Patterned wafer: Silicon wafer 1 where 500 nm-depth trenches 2 and 25 nm-thick tantalum as a barrier film 4 are formed, and a copper film 5 is coated to a thickness of 1,000 nm (see, Fig. 1, upper view). Here, a copper line 2' or 2" is disposed between spaces 3 or 3".

### <Polishing of 8-Inch Wafer>

Relative speed of substrate to polishing platen: 70 m/min
Polishing pad: IC1000/SUBA400 (produced by Rodel Nitta)
Polishing composition supply rate: 200 ml/min

### <Evaluation of Polishing Properties>

### (Measurement of step)

A contact-type step meter was used.

### (Measurement of thickness of blanket copper and tantalum film)

The thickness was determined based on the sheet resistance.

### (Measurement of thickness of patterned copper film)

The thickness was determined based on the sheet resistance of pattern-free copper film in the vicinity of the site to be evaluated.

### (Measurement of polishing speed)

The thickness of each of the copper film and barrier film was based on electric resistance values before and after polishing, and the polishing speed was calculated on the basis of polishing time.

### (Evaluation of dishing)

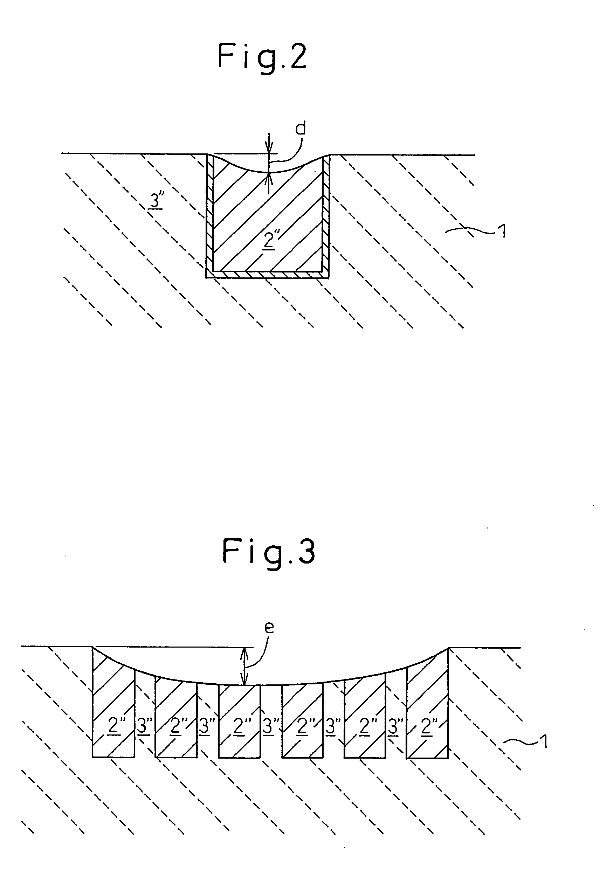

Based on the polishing speed of the case that the patterned wafer above (line/space of 100 µm/100 µm, see upper view of Fig. 1) was polished to leave about 300 nm of copper, a substrate having a line/space copper pattern of 100 µm/100 µm was polished up to 50% overpolish (polished plus 50% from the middle view of Fig. 1) with respect to the initial copper film thickness. The step generated on the copper pattern (d in Fig. 2) was evaluated as dishing.

### (Measurement of erosion)

Based on the polishing speed in the case that the similar patterned wafer as above (line/space of 9 µm/1 µm) was polished to leave about 300 nm of copper, a substrate having line/space pattern of 9 µm/1 µm was polished up to 50% overpolish with respect to the initial copper film thickness. The loss of barrier film and interlayer dielectric film in the space part (e of Fig. 3) was measured as erosion.

### <<Examples 1 to 10 and Comparative Examples 1 and 2>>

Evaluation of a 8-inch wafer (200 mm wafer) was performed by using a polishing machine SH-24 (manufactured by SpeedFam Co., Ltd). The wafer was polished at a relative speed of substrate to polishing platen of 70 m/min, a polishing composition supply rate of 200 ml/min and a pressure of 15 kPa.

The polishing pad used was IC1400 (k groove) produced by Rodel Nitta. The composition is shown in Table 1. The component added other than those shown in the table is water, and the amount added is shown by mass%. APS denotes ammonium persulfate, DBS denotes dodecylbenzenesulfonic acid, POE denotes polyoxyethylene secondary alkyl ether phosphoric ester, OLA denotes oleic acid, and BZI denotes benzimidazole. The colloidal silica used had a particle diameter of 120 nm.

**Table 1**

| Example | Azole | Acid | Oxidant | Surfactant | Anticorrosion agent | Alkali | Abrasive | pH |
|---|---|---|---|---|---|---|---|---|
| Example 1 | Compound A 0.03% | oxalic acid 0.5% | APS 1.5% | DBS 0.06% POE 0.01% OLA 0.03% | BZI 0.003% | ammonia | colloidal silica 0.75% | 9.1 |
| Example 2 | Compound B 0.05% | oxalic acid 0.5% | APS 1.5% | DBS 0.06% POE 0.01% OLA 0.03% | BZI 0.003% | ammonia | colloidal silica 0.75% | 9.1 |
| Example 3 | Compound C 0.05% | oxalic acid 0.5% | APS 1.5% | DBS 0.06% POE 0.01% OLA 0.03% | BZI 0.003% | ammonia | colloidal silica 0.75% | 9.1 |
| Example 4 | Compound D 0.05% | oxalic acid 0.5% | APS 1.5% | DBS 0.06% POE 0.01% OLA 0.03% | BZI 0.003% | ammonia | colloidal silica 0.75% | 9.1 |
| Example 5 | Compound G 0.05% | oxalic acid 0.5% | APS 1.5% | DBS 0.06% POE 0.01% OLA 0.03% | BZI 0.003% | ammonia | colloidal silica 0.75% | 9.1 |
| Example 6 | Compound F 0.05% | oxalic acid 0.5% | APS 1.5% | DBS 0.06% oleyl phosphoric ester 0.01% OLA 0.03% | BZI 0.003% | ammonia | colloidal silica 0.75% | 9.1 |
| Example 7 | Compound E 0.05% | oxalic acid 0.5% | APS 1.5% | DBS 0.07% POE 0.01% OLA 0.03% | BZI 0.003% | ethylene-diamine 0.01% + ammonia | colloidal silica 0.75% | 9.0 |
| Example 8 | Compound E 0.05% | oxalic acid 0.5% | APS 1.5% | DBS 0.07% POE 0.01% OLA 0.03% | BZI 0.003% | ammonia | colloidal silica 1.0% | 9.1 |
| Example 9 | Compound E 0.05% | oxalic acid 0.5% | APS 1.5% | DBS 0.07% POE 0.01% OLA 0.03% | BZI 0.003% | ammonia | colloidal silica 1.2% | 9.1 |
| Example 10 | Compound E 0.05% | oxalic acid 0.5% | APS 1.5% | DBS 0.07% POE 0.01% OLA 0.03% | BZI 0.003% | ammonia | colloidal silica 1.5% | 9.0 |
| Comparative Example 1 | Compound 72W 0.05% | oxalic acid 0.5% | APS 1.5% | DBS 0.07% POE 0.03% OLA 0.03% | BZI 0.005% | ammonia | colloidal silica 0.75% | 9.0 |
| Comparative Example 2 | polyethyleneimine having a molecular weight of 2,000 in place of azole 0.075% | oxalic acid 0.5% | APS 1.5% | DBS 0.07% POE 0.01% OLA 0.03% | BZI 0.003% | ammonia | colloidal silica 1.5% | 9.0 |

| | | | | | | | | |
|---|---|---|---|---|---|---|---|---|
| (% is mass%) | | | | | | | | |

The results are shown in Table 2. The copper roughness of the patterned wafer was evaluated as follows. The patterned wafer which had been polished was enlarged from 10 to 100 times by a metal microscope, and whether discoloration to dark brown was observed in the copper potion was confirmed. It is known, from SEM observation, that a discoloration to dark brown indicates production of fine holes. When this discoloration was observed, the wafer was judged to be rough. As for the residual copper, the wafer was also enlarged from 10 to 100 times by using a metal microscope and observed, and the residual copper mottle and residual copper hump which becomes a problem on the narrow wiring of 0.25 µ/0.25 µ were evaluated. When residual copper mottle is observed, this indicates that residual copper is present in a wider region.

In Examples 1 to 5 and Comparative Example 1, various vinyl imidazole and 1-vinylpyrrolidone copolymers were used as the azoles, and other additives were the same. The dishing was slightly large in Example 5 wherein azoles having a molecular weight of 1,800 was used, but in all cases, the dishing and erosion were low and particularly in Comparative Example using Compound 72W having a large molecular weight, the same performance was obtained by the addition in a small amount.

However, in Comparative Example 1 using the azole group-containing compound 72W having a molecular weight of 220,000, a lot of residual copper was observed after the completion of polishing, and not only residual copper mottle throughout the wafer but also residual hump were observed. This is not a problem in the case of using a barrier polishing slurry capable of correction even if residual copper is slightly present. However, in other cases, the large molecular weight imposes limitations on the kind of polishing which can be applied. On the other hand, in Example 1 using a compound having a molecular weight of 10,500, residual hump was slightly observed and in Examples 2 to 4 using compounds having a molecular weight of approximately from 5,000 to 6,000, residual copper was not observed at all. It is apparent from these results that the residual copper depends on the molecular weight of the compound having 3 or more azole groups.

In Example 6 wherein oleyl phosphoric ester was used as the phosphoric ester, all performances were good. In Example 7 wherein polishing was performed by adding a small amount of ethylenediamine as an alkali, dishing is slightly large. Depending on the process, dishing to a certain extent is sometimes necessary, and in this case, addition of ethylenediamine is effective.

In Examples 8 to 10 wherein the amount of colloidal silica added was changed, dishing tended to slightly increase as the amount added is increased, but did not become so large.

Incidentally, in Examples 1 to 10 and Comparative Example 1, roughening of the wiring copper of the pattern wafer was not confirmed. In Comparative Example 2 wherein polyethyleneimine having a molecular weight of 2,000 was added in place of azoles, when additives other than abrasive and oxidant were dissolved and then the abrasive was added, the white color was gradually thickened and separation into two layers started. When the oxidant was further added, the separation was more accelerated, and the abrasive was aggregated and precipitated. The composition of Comparative Example 2 cannot be used for polishing.

**Table 2**

| Example, Comparative Example | Cu (Blanket) Removal Rate | Cu (Pattern) Removal Rate | Dishing | Erosion | Residual Copper of Pattern Wafer | Roughen-ing of Wiring Copper of Pattern Wafer |
|---|---|---|---|---|---|---|
| Example 1 | 510 nm/min | 585 nm/min | 12 nm | 10 nm | Residual copper hump was slightly confirmed. | none |
| Example 2 | 511 nm/min | 588 nm/min | 22 nm | 7 nm | no residual copper | none |
| Example 3 | 506 nm/min | 614 nm/min | 3 nm | 10 nm | no residual copper | none |
| Example 4 | 489 nm/min | 602 nm/min | 8 nm | 18 nm | no residual copper | none |
| Example 5 | 522 nm/min | 619 nm/min | 44 nm | 9 nm | no residual copper | none |
| Example 6 | 490 nm/min | 588 nm/min | 8 nm | 10 nm | no residual copper | none |
| Example 7 | 419 nm/min | 584 nm/min | 37 nm | 7 nm | no residual copper | none |
| Example 8 | 612 nm/min | 731 nm/min | 56 nm | 6 nm | no residual copper | none |
| Example 9 | 606 nm/min | 736 nm/min | 71 nm | 5 nm | no residual copper | none |
| Example 10 | 587 nm/min | 729 nm/min | 82 nm | 8 nm | no residual copper | none |
| Comparative Example 1 | 512 nm/min | 679 nm/min | 8 nm | 6 nm | Thin residual copper mottle throughout the wafer and residual copper hump were observed. | none |

### <<Examples 11 to 14>>

Evaluation of a 8-inch wafer was performed by using a polishing machine, Mirra (manufactured by Applied Material, Inc). The wafer was polished at a relative speed of substrate to polishing platen of 75 m/min, a polishing composition supply rate of 200 ml/min and a pressure of 14 kPa.

The polishing pad used was IC1000 (k groove) produced by Rodel Nitta. The composition is shown in Table 3. The component added other than those shown in the table is water, and the amount added is shown by mass%. APS denotes ammonium persulfate, DBS denotes dodecylbenzenesulfonic acid, POE denotes polyoxyethylene secondary alkyl ether phosphoric ester, OLA denotes oleic acid, and BZI denotes benzimidazole. The colloidal silica used had a particle diameter of 120 nm.

**Table 3**

| Example | Azole | Acid | Oxidant | Surfactant | Anticorrosion agent | Alkali | Abrasive | pH |
|---|---|---|---|---|---|---|---|---|
| Example 11 | Compound F 0.05% | oxalic acid 0.5% | APS 1.5% | DBS 0.07% POE 0.003% OLA 0.01% | BZI 0.007% | ammonia | colloidal silica 1.5% | 9.1 |
| Example 12 | Compound F 0.05% | oxalic acid 0.5% | APS 1.5% | DBS 0.07% POE 0.005% OLA 0.01% | BZI 0.007% | ammonia | colloidal silica 1.5% | 9.1 |
| Example 13 | Compound F 0.05% | oxalic acid 0.5% | APS 1.5% | DBS 0.07% POE 0.0085% OLA none | BZI 0.007% | ammonia | colloidal silica 1.5% | 9.1 |
| Example 14 | Compound F 0.05% | oxalic acid 0.5% | APS 1.5% | DBS 0.07% POE 0.01% OLA none | BZI 0.007% | ammonia | colloidal silica 1.5% | 9.1 |

The results are shown in Table 4. The residual copper and copper roughness were evaluated in the same manner as in Example 1. Examples 11 and 12 are a polishing composition wherein oleic acid is added, and Examples 13 and 14 are a slurry wherein oleic acid is not added. In Examples 11 and 12, the performance in terms of dishing and erosion is slightly high as compared with Examples 13 and 14 and particularly, an effect by the addition of oleic acid on the copper roughening on the wiring portion was confirmed. Whether the effect of preventing copper roughening is exerted by the oleic acid alone or by the synergy, for example, with the azole group-containing compound having 3 or more azole groups within the molecule is not known, but it can be seen that addition of oleic acid in the present invention is preferred.

**Table 4**

| Example | Cu (Blanket) Removal Rate | Dishing | Erosion | Residual Copper of Patterned Wafer | Roughening of Wiring Copper of Patterned Wafer |
|---|---|---|---|---|---|
| Example 11 | 714 nm/min | 0 nm | 18 nm | no residual copper | none |
| Example 12 | 690 nm/min | 0 nm | 14 nm | no residual copper | none |
| Example 13 | 660 nm/min | 21 nm | 40 nm | no residual copper | brown roughening on wiring portion |
| Example 14 | 710 nm/min | 20 nm | 40 nm | no residual copper | brown roughening on wiring portion |

### <<Examples 15 to 17>>

Evaluation of a 8-inch wafer was performed by using a polishing machine, SH-24, manufactured by SpeedFam Co., Ltd. The wafer was polished at a relative speed of substrate to polishing platen of 83 m/min, a polishing composition supply rate of 150 ml/min and a pressure of 7 kPa. The copper polishing speed and the performance in terms of dishing and erosion were compared at high temperature.

The polishing pad used was IC1400 (k groove) produced by Rodel Nitta. The composition is shown in Table 5. The component added other than those shown in the table is water, and the amount added is shown by mass%. APS denotes ammonium persulfate, DBS denotes dodecylbenzenesulfonic acid, POE denotes polyoxyethylene secondary alkyl ether phosphoric ester, OLA denotes oleic acid, and BZI denotes benzimidazole. The colloidal silica used had a particle diameter of 120 nm. In polishing at high temperature, the temperature of the slurry comprising the oxidant was elevated for over 30 minutes, and the slurry was immediately used for polishing.

**Table 5**

| Example | Azole | Acid | Oxidant | Surfactant | Anticorrosion agent | Alkali | Abrasive | pH |
|---|---|---|---|---|---|---|---|---|
| Examples 15 to 17 | Compound F 0.05% | oxalic acid 0.5% | APS 1.5% | DBS 0.07% POE 0.003% OLA 0.03% | BZI 0.003% | ammonia | colloidal silica 1.5% | 9.1 |

The results are shown in Table 6. The polishing is usually performed near room temperature (22°C), but when the polishing was performed at an elevated temperature of 40°C or 50°C, the polishing speed was high and the performance in terms of dishing and erosion was enhanced.

**Table 6**

| Example | Polishing Temperature | Cu (Blanket) Removal Rate | Cu (Pattern) Removal Rate | Dishing | Erosion |
|---|---|---|---|---|---|
| Example 15 | 22°C | 539 nm/min | 641 nm/min | 53 nm | 10 nm |
| Example 16 | 40°C | 628 nm/min | 694 nm/min | 34 nm | 9 nm |
| Example 17 | 50°C | 638 nm/min | 706 nm/min | 22 nm | 10 nm |

### <<Examples 18 to 26>>

In these Examples, suppression of corrosion was examined.

Evaluation of a 8-inch wafer was performed by using a polishing machine, Mirra (manufactured by Applied Material, Inc). The wafer was polished at a relative speed of substrate to polishing platen of 75 m/min, a polishing composition supply rate of 150 ml/min and a pressure of 14 kPa.

The polishing pad used was IC1000 (k-XY groove) produced by Rodel Nitta. The composition is shown in the table below. The component added other than those shown in the table is water, and the amount of such a component is shown by mass%. APS denotes ammonium persulfate, DBS denotes dodecylbenzenesulfonic acid, POE denotes polyoxyethylene secondary alkyl ether phosphoric ester, OLA denotes oleic acid, BZI denotes benzimidazole, and Phe denotes phenylalanine. The colloidal silica used had a particle diameter of 120 nm.

**Table 7**

| Example | Azole | Acid | Oxidant | Surfactant | Anticorrosion agent | Alkali | Abrasive | Others | pH |
|---|---|---|---|---|---|---|---|---|---|
| Example 18 | Compound E 0.05% | oxalic acid 0.5% | AP 1.5% | DBS 0.07% POE 0.005% OLA 0.01% | BZI 0.005% | ammonia | colloidal silica 1.5% | | 9.3 |
| Example 19 | Compound E. 0.05% | oxalic acid 0.5% | APS 1.5% | DBS 0.07% POE 0.005% OLA 0.01% | BZI 0.005% | ammonia | colloidal silica 1.5% | polyvinyl alcohol 0.08% | 9.3 |
| Example 20 | Compound E 0.05% | oxalic acid 0.5% | APS 1.5% | DBS 0.07% POE 0.005% OLA 0.01% | BZI 0.005% | ammonia | colloidal silica 1.5% | | 9.3 |
| Example 21 | Compound E 0.05% | oxalic acid 0.5% | APS 1.5% | DBS 0.07% POE 0.005% OLA 0.01% | BZI 0.005% | ammonia | colloidal silica 1.5% | polyvinyl-pyrrolidone 0.1% | 9.3 |
| Example 22 | Compound E 0.05% | oxalic acid 0.5% | APS 1.5% | DBS 0.07% POE 0.005% OLA 0.01% | BZI 0.005% | ammonia | colloidal silica 1.5% | Compound H 0.1% | 9.3 |
| Example 23 | Compound E 0.05% | oxalic acid 0.5% | APS 1.5% | DBS 0.07% POE 0.005% OLA 0.01% | BZI 0.005% | ammonia | colloidal silica 1.5% | compound I 0.1% | 9.3 |
| Example 24 | Compound C 0.05% | oxalic acid 0.5% | APS 1.5% | DBS 0.07% POE 0.005% OLA 0.01% | BZI 0.007% | ammonia | colloidal silica 1.5% | | 9.3 |
| Example 25 | Compound C 0.05% | oxalic acid 0.5% Phe 0.2% | APS 1.5% | DBS 0.07% POE 0.005% OLA 0.01% | BZI 0.007% | ammonia | colloidal silica 1.5% | | 9.3 |
| Example 26 | Compound E 0.05% | oxalic acid 0.5% Phe 0.2% | APS 1.5% | DBS 0.07% POE 0.005% OLA 0.01% | BZI 0.007% | ammonia | colloidal silica 1.5% | polyvinyl-pyrrolidone 0.1% | 9.3 |

In the evaluation of corrosion, a 100 µ/100 µ square in the center of the wafer was observed by SEM at a magnification of 50,000, and a relative evaluation on a seven-level scale of A to G was performed. More specifically, the sample was rated A when corrosion was not observed in the viewing field, rated B when slightly observed, and rated C, D, E and F as the corrosion was increased, with rating of G when almost the entire region in the viewing field was corroded.

In Example 19 wherein polyvinyl alcohol was added, the removal rate was slightly low as compared with Example 18 wherein polyvinyl alcohol was not added, but the performance in terms of dishing and erosion was remarkably good and the wafer was not corroded.

The polyvinylpyrrolidone (produced by Aldrich, molecular weight: 10,000) added in Example 21 did not affect the removal rate, dishing and erosion but had an effect of eliminating corrosion. The nonionic water-soluble polymer (Compounds H and I) used in Examples 22 and 23 also did not affect the removal rate, dishing and erosion but had an effect of suppressing corrosion. In Examples 25 and 26, phenylalanine was also added as the acid in addition to oxalic acid. When phenylalanine was also added, corrosion was more suppressed.

**Table 8**

| Example, Comparative Example | Supply Rate, ml/min | Cu (Blanket) Removal Rate | Dishing | Erosion | Corrosion |
|---|---|---|---|---|---|
| Example 18 | 150 | 991 nm/min | 12.8 nm | 21.5 nm | D |
| Example 19 | 150 | 860 nm/min | 0.0 nm | 9.4 nm | C |
| Example 20 | 200 | 1115 nm/min | 15.9 nm | 17.0 nm | C |
| Example 21 | 200 | 1158 nm/min | 14.4 nm | 24.4 nm | A |
| Example 22 | 150 | 923 nm/min | 11.3 nm | 16.6 nm | C |
| Example 23 | 150 | 822 nm/min | 7.2 nm | 21.2 nm | C |
| Example 24 | 100 | 773 nm/min | 0.0 nm | 7.0 nm | C |
| Example 25 | 100 | 862 nm/min | 0.0 nm | 12.3 nm | B |
| Example 26 | 100 | 924 nm/min | 0.0 nm | 7.3 nm | A |

### <<Examples 27 and 28 and Comparative Examples 3 to 6>>

Evaluation of a 8-inch wafer was performed by using a polishing machine, Mirra (manufactured by Applied Material, Inc). The wafer was polished at a relative speed of substrate to polishing platen of 75 m/min, a polishing composition supply rate of 200 ml/min and a pressure of 14 kPa.

The polishing pad used was IC1000 (k-XY groove) produced by Rodel Nitta. The composition is shown in the table below. The component other than those shown in the Table is water, and the amount of such a component is shown by mass%. APS denotes ammonium persulfate, DBS denotes dodecylbenzenesulfonic acid, POE denotes polyoxyethylene secondary alkyl ether phosphoric ester, OLA denotes oleic acid, and BZI denotes benzimidazole. The colloidal silica used had a particle diameter of 120 nm, the polyacrylamide (produced by Aldrich) used had a molecular weight of 10,000, and the polyacrylic acid (produced by Wako Pure Chemical Industries, Ltd.) used had a molecular weight of 25,000.

**Table 9**

| Example, Comparative Example | Abrasive Grain | Azole | Acid | Oxidant | Surfactant | Anticorrosion agent | Alkali | pH |
|---|---|---|---|---|---|---|---|---|
| Example 27 | colloidal silica 1.5% | Compound E 0.05% | oxalic acid dihydrate 0.7% | ammonium persulfate 1.5% | DBS 0.07% OLA 0.005% | BZI 0.005% | ammonia 0.32% | 9.3 |
| Example 28 | Same as above | Compound E 0.05% | Same as above | Same as above | Same as above | none | Same as above | 9.3 |
| Comparative Example 3 | Same as above | Compound E none | Same as above | Same as above | Same as above | BZI 0.005% | Same as above | 9.3 |
| Comparative Example 4 | Same as above | Compound E none | Same as above | Same as above | Same as above | none | Same as above | 9.3 |
| Comparative Example 5 | Same as above | polyacrylamide 0.05% | Same as above | Same as above | Same as above | BZI 0.005% | Same as above | 9.3 |
| Comparative Example 6 | Same as above | Compound E 0.05% polyacrylic acid 0.01% | Same as above | Same as above | Same as above | Same as above | Same as above | 9.3 |

In Comparative Example 4 wherein a composition did not contain an azole compound nor an anticorrosion agent, dishing and erosion both were large. In Comparative Example 3 wherein a composition was obtained by adding BZI as an anticorrosion agent to the composition of Comparative Example 4, dishing and erosion both were not changed. On the other hand, in Example 28 wherein only an azole compound was added, dishing and erosion both were improved. In Example 27 wherein BZI as an anticorrosion agent was further added, dishing was smaller.

With respect to Example 27 and Comparative Example 3, the Ta polishing speed was measured, and how the polishing speed was changed by the addition of an azole compound was examined. As a result, the Ta polishing speed was slightly decreased when an azole compound was added.

In Comparative Example 5 wherein polyacrylamide was added in place of the azole compound, the performance in terms of dishing was slightly improved, but the erosion remained significantly large. In Comparative Example 6, polyacrylic acid which is an anionic polymer was added to the composition of Example 27. Another water-soluble polymer can be added within the range of not inhibiting the present invention but under the conditions above, the polyacrylic acid not only causes significantly large dishing but also generates many corrosions on the copper film surface.

In Japanese Unexamined Patent Publication No. 11-195628, it is stated that a water-soluble polymer combined with an anticorrosion agent such as benzotriazole can increase the removal rate as well as greatly reduce the etching rate, whereby dishing can be reduced.

However, according to the present invention, a water-soluble polymer alone has an effect on the suppression of dishing and erosion, and when benzimidazole as an anticorrosion agent is added thereto, the dishing is more successfully suppressed. Also, the copper removal rate or etching rate does not greatly differ depending on the presence or absence of an anticorrosion agent. From these, the mechanism of the present invention is presumed to be different from that of Japanese Unexamined Patent Publication No. 11-195628. This is clearly seen also from the fact that, in Comparative Examples 3 and 4 using polyacrylamide or polyacrylic acid supposed to be useful in Japanese Unexamined Patent Publication No. 11-195628, the performance is not improved but depending on the case performance is greatly deteriorated.

**Table 10**

| Example, Comparative Example | Cu (Blanket) Removal Rate | Etching Rate | Ta (Blanket) Removal Rate | Dishing | Erosion |
|---|---|---|---|---|---|
| Example 27 | 991 nm/min | 0.5 nm/min | 3.0 nm/min | 12.8 nm | 21.5 nm |
| Example 28 | 1083 nm/min | 0.8 nm/min | | 34.9 nm | 18.9 nm |
| Comparative Example 3 | 1065 nm/min | 0.6 nm/min | 5.0 nm/min | 47.2 nm | 73.6 nm |
| Comparative Example 4 | 1098 nm/min | 0.6 nm/min | | 49.2 nm | 64.6 nm |
| Comparative Example 5 | 1090 nm/min | | | 30.0 nm | 64.2 nm |
| Comparative Example 6 | 1127 nm/min | | | 285.7 nm | 14.5 nm |

## Claims

1. A polishing composition comprising:
(A) an azole group-containing compound having 3 or more azole groups within the molecule and a molecular weight of 300 to 15,000,
(B) an oxidant, and
(C) one, two or more acids selected from the group consisting of an amino acid, an organic acid and an inorganic acid.

2. The polishing composition according to claim 1, wherein the molecular weight of said azole group-containing compound is from 2,000 to 8,000.

3. The polishing composition according to claim 1 or 2, wherein said azole group-containing compound is a polymer containing an azole unit having a vinyl group.

4. The polishing composition according to any one of claims 1 to 3, wherein the content of said azole group-containing compound is from 0.001 to 1 mass%.

5. The polishing composition according to any one of claims 1 to 4, wherein the molecular weight per one azole group of said azole group-containing compound is from 90 to 300.

6. The polishing composition according to any one of claims 1 to 5, wherein the polishing composition further comprises an abrasive.

7. The polishing composition according to claim 6, wherein the content of said abrasive is 30 mass% or less.

8. The polishing composition according to any one of claims 1 to 7, wherein the polishing composition further comprises an alkyl aromatic sulfonic acid having a carbon number of 8 or more.

9. The polishing composition according to claim 8, wherein the content of said alkyl aromatic sulfonic acid is 0.5 mass% or less.

10. The polishing composition according to any one of claims 1 to 9, wherein the polishing composition further comprises a phosphoric ester with an alkyl group having a carbon number of 8 or more.

11. The polishing composition according to claim 10, wherein the content of said phosphoric ester with an alkyl group having a carbon number of 8 or more is 0.5 mass% or less.

12. The polishing composition according to any one of claims 1 to 11, wherein the polishing composition further comprises a fatty acid having a carbon number of 8 or more.

13. The polishing composition according to claim 12, wherein the content of said fatty acid is 0.5 mass% or less.

14. The polishing composition according to any one of claims 1 to 13, wherein the polishing composition further comprises an anticorrosion agent.

15. The polishing composition according to claim 14, wherein the content of said anticorrosion agent is 0.5 mass% or less.

16. The polishing composition according to any one of claims 1 to 15, wherein the polishing composition further comprises an alkali.

17. The polishing composition according to any one of claims 1 to 16, wherein the pH is from 5 to 11.

18. The polishing composition according to any one of claims 1 to 17, wherein the polishing composition further comprises a nonionic water-soluble polymer.

19. The polishing composition according to claim 18, wherein said nonionic water-soluble polymer is a polymer of vinyl alcohol, vinylpyrrolidone, acryloylmorpholine or N-isopropylacrylamide, or a copolymer of a combination thereof.

20. The polishing composition according to claim 18 or 19, wherein the content of said nonionic water-soluble polymer is 5 mass% or less.

21. The polishing composition according to any one of claims 18 to 20, wherein the molecular weight of said nonionic water-soluble polymer is from 3,000 to 100,000.

22. The polishing composition according to any one of claims 1 to 21, wherein the polishing composition is used for polishing a metal film embedded in and covering a recess on a substrate, or for polishing a barrier metal film formed on a substrate having a recess and a metal film embedded in and covering the recess.

23. A method for polishing a substrate, wherein the method comprises planarizing, with use of the polishing composition of any one of claims 1 to 21, a metal film embedded in and covering a recess on a substrate, or a barrier metal film formed on a substrate having a recess and a metal film embedded in and covering the recess.

24. The method for polishing a substrate according to claim 23, wherein the planarization is performed with the temperature of said polishing composition set to 30 to 50°C.

25. The method for polishing a substrate according to claim 23 or 24, wherein said metal film is copper or a copper-containing alloy film.

26. The method for polishing a substrate according to any one of claims 23 to 25, wherein said barrier metal film is tantalum or a tantalum alloy film.

27. A method for producing a substrate, wherein the method comprises polishing a substrate by the polishing method of any one of claims 23 to 26.

28. A composition which becomes the polishing composition of any one of claims 4, 7, 9, 11, 13 and 15 when diluted.

29. A method for using the composition of claim 28 as a composition for transportation or storage.

30. A kit comprising a plurality of compositions, which form the polishing composition of any one of claims 1 to 22 when said compositions are mixed or mixed and diluted.

31. A method for using the kit of claim 30 as compositions for transportation or storage.
